Europäisches Patentamt

European Patent Office

Office européen des brevets

(11) Veröffentlichungsnummer : **0 351 697 B1**

(12) **EUROPÄISCHE PATENTSCHRIFT**

⑪

(19)

(45) Veröffentlichungstag der Patentschrift :
**10.06.92 Patentblatt 92/24**

(21) Anmeldenummer : **89112696.3**

(22) Anmeldetag : **11.07.89**

(51) Int. Cl.$^5$ : **H03K 5/08**

(54) **Schaltung zur Umwandlung.**

Verbunden mit 89907752.3/0430959
(europäische
Anmeldenummer/Veröffentlichungsnummer)
durch Entscheidung vom 26.07.91.

(30) Priorität : **20.07.88 DE 3824557**

(43) Veröffentlichungstag der Anmeldung :
**24.01.90 Patentblatt 90/04**

(45) Bekanntmachung des Hinweises auf die
Patenterteilung :
**10.06.92 Patentblatt 92/24**

(84) Benannte Vertragsstaaten :
**AT BE CH DE ES FR GB GR IT LI LU NL SE**

(56) Entgegenhaltungen :
**EP-A- 0 057 766**
**EP-A- 0 087 501**
**PATENT ABSTRACTS OF JAPAN, Band 8, Nr.**
**92 (P-271)[1529], 27. April 1984 & JP-A-59 5962**

(73) Patentinhaber : **Deutsche Thomson-Brandt
GmbH
Hermann-Schwer-Strasse 3 Postfach 1307
W-7730 Villingen-Schwenningen (DE)**

(72) Erfinder : **Link, Hermann, Dipl.-Ing.
Augenmoosstrasse 10
W-7730 VS-Obereschach (DE)**
Erfinder : **Sturm, Walter, Dipl.-Ing.
Hirschweg 3
W-7333 Ebersbach/Fils (DE)**

(74) Vertreter : **Körner, Peter, Dipl.-Ing.
Deutsche Thomson-Brandt GmbH Patent- und
Lizenzabteilung Göttinger Chaussee 76
W-3000 Hannover 91 (DE)**

EP 0 351 697 B1

**Beschreibung**

Operationsverstärker sind Gleichspannungsverstärker mit einer hohen Verstärkung, deren Eingangsschaltung als Differenzverstärker ausgebildet ist. Störend wirkt sich bei Verwendung eines Operationsverstärkers als Wechselspannungsverstärker eine dem Wechselspannungseingangssignal überlagerte Gleichspannung, auch DC-Offset genannt, aus, da dadurch eine Potentialverschiebung am Ausgang bewirkt wird, die in bestimmten Anwendungsfällen, z. B. bei einer galvanischen Kopplung mehrerer Operationsverstärker, unerwünscht sein kann. Es ist bekannt, diese Potentialverschiebungen durch kapazitive Ankopplung, oder bei bekannten konstantem DC-Offset durch Anlegen von Kompensationsspannungen zu eliminieren.

Aus der Druckschrift EP-A-0 087501 ist eine Trigaerschaltung bekannt, die aus einem hohen und tiefe Frequenzen aufweisenden Frequenzgemisch die Anteile der höchsten Frequenzen ableitet und in Rechteckimpulse umwandelt. Es wird eine Schaltung vorgeschlagen, die einen Spitzenspannungsdetektor aus einem ersten Operationsverstärker mit einer Antiparallelschaltung von zwei Dioden im Gegenkopplungsweg aufweist, deren erster Eingang den Eingang der Triggerschaltung bildet und deren zweiter Eingang über einen Kondensator mit einem festen Potential verbunden ist. An den Spitzenspannungsdetektor schließt sich ein Komparator an, der einen zweiten Operationsverstärker enthält, dessen erster Eingang mit dem Ausgang des ersten Operationsverstärkers und dessen zweiter Eingang mit dem erster Eingang des ersten Operationsverstärkers verbunden ist.

Es ist Aufgabe der Erfindung eine Schaltung aufzuzeigen, bei der aus einer Eingangwechselspannung bekannter Amplitude mit einem nicht bekannten DC-Offset mittels galvanischer Kopplung zweier Operationsverstärker eine Rechteckspannung abgeleitet wird.

Diese Aufgabe wird gemäß der Erfindung durch die im Anspruch 1 aufgeführten Merkmale gelöst. Weiterbildungen der Erfindung sind in den Unteransprüchen gekennzeichnet.

Durch Anwendung der Schaltung nach dem Patentanspruch 1 wird für den ersten, die Wechselspannungsverstärkung bewirkenden Operationsverstärker dafür gesorgt, daß sich sofort bei Erreichen des ersten Wechselspannungsmaximums oder Minimums eine Gleichspannungsverstärkung von v =1 einstellt. Dieses wird durch Verwendung zweier antiparallel geschalteter Dioden im Gegenkopplungszweig erreicht, durch die ein im Fußpunkt der Wechselspannungsgegenkopplung befindliche Kondensator, unabhängig von der Größe der Gegenkopplungswiederstän de, d.h. ohne eine Zeitkonstante, sofort auf das Potential des am Eingang stehenden unbekannten DC-Offsets aufgeladen wird. Da der DC-Offset am Ausgang des Verstärkers im Wert mit dem DC-Offset am Eingang übereinstimmt, ist es möglich, die Eingänge des als Komparator arbeitenden zweiten Operationsverstärker direkt auf dieses Potential zu beziehen. Aus dem Vergleich der verstärkten Wechselspannung am Ausgang des ersten Operationsverstärkers mit der Eingangsspannung kann ein Rechtecksignal ohne, oder nur mit geringem konstanten DC-Offset erzeugt werden, da der DC-Anteil an beiden Eingängen des Komparators etwa gleich groß ist.

Die Größe der überlagerten verstärkten Wechselspannung am Ausgang des ersten Operationsverstärkers ist durch die Wahl der die Gegenkopplung bildenden Wiederstände bestimmt. Sie ist kleiner als die Durchlaßspannung von z.B. $\pm 0,7$ Volt der antiparallel geschalteten Dioden, so daß keine begrenzende Wirkung durch die Dioden erfolgen kann. Für die sich einstellende Gleichspannung A am Ausgang des ersten Operationsverstärkers gilt die Beziehung A = UC $\pm$ UF wobei UC die Spannung am Kondensator und UF die Durchlaßspannung der Dioden ist.

Die Schaltung ist für die Umwandung kleiner Wechselspannungen in Rechteckspannungen besonders geeignet, wobei der am Eingang des ersten Operationsverstärkers anstehenden Wechselspannung mit bekannter konstanter Maximalamplitude eine größere, im Wert unbekannte DC-Offsetspannung überlagert ist. Diese Konstellation ist z.B. gegeben, wenn mittels magnetfeldabhängiger Sensoren, wie sie z.B. von der Firma Sony als Magneto-resistance Elemente angeboten werden, bei einem Gleichstrommotor mit Magnetpole aufweisenden Rotor der Komutierungszeitpunkt ermittelt werden soll. Derartige Gleichstrommotore werden z.B. als Capstan-Motor in Magnetbandrecordern verwendet.

Im folgenden soll die Erfindung anhand einer Figur beispielhaft näher erläutert werden.

Fig. 1 zeigt in einem Schaltbild die Umwandung einer in Magnetfeld abhängigen Sensoren erzeugten sinusförmigen Wechselspannung mit DC-Offset in eine Rechteckspannung.

Fig. 2 zeigt Kurvenverläufe an verschiedenen Punkten der Schaltung nach Fig.1

Fig. 3 zeigt Einschwing- und Ausschwingvorgänge in der nach Fig. 1 ausgeführten Schaltung.

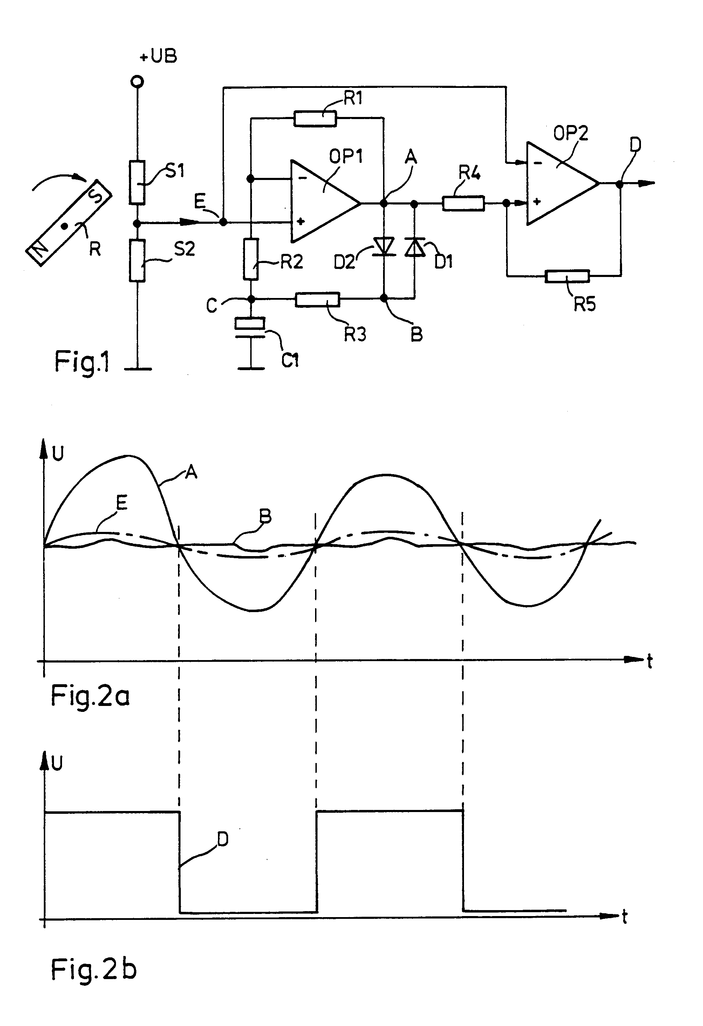

Fig. 1 zeigt in einem Schaltbild die Umwandlung einer in Magnetfeld abhängigen Sensoren erzeugten sinusförmigen Wechselspannung mit DC-Offset in eine Rechteckspannung. In den Magnetfeldabhängigen Sensoren S1 und S2, die in Reihe zwischen +UB und Bezugspotential (Masse) geschaltet sind, wird durch einen Magnetpolpaare N,S tragenden Rotor R bei dessen Drehung eine sinusförmige Wechselspannung erzeugt, die mit einem Gleichspannungsoffset am Verbindungspunkt E der beiden Sensoren behaftet ist. Die

EP 0 351 697 B1

Gröbe des Offsets ergibt sich aus den Gleichstromwiderständen der Sensoren und der angelegten Spannung +UB. Die am Verbindungspunkt E stehende Offset behaftete Wechselspannung wird einerseits dem als Verstärker arbeitenden Operationsverstärker OP1 an dessen nich-tinvertierenden, und dem als Komparator arbeitenden Operationsverstärker OP2 an dessen invertierenden Eingang zugeführt. Die Wechselspannungsverstärkung in OP1 ist durch eine als Spannungsteiler ausgebildete Gegenkopplungssschaltung eingestellt, die aus einem hochohmigen Widerstand R1 zwischen Ausgang A und invertierendem Eingang, sowie durch eine am invertierenden Eingang angeschaltete Reihenschaltung von Widerstand R2 mit einem nach Masse geschalteten Kondensator C1 gebildet ist.

Durch diese ansich bekannte Gegenkopplungsschaltung wird auch der am Ausgang A stehende Gleichspannungsanteil auf den invertierten Eingang von OP1 zurückgeführt. Bei Anlegen der Betriebsspannung wird Kondensator C1 entsprechend der schaltungsgemäß ausgebildeten Zeitkonstante (R1, R2, C1) aufgeladen, sodaß erst nach-einer durch die Zeitkonstante vorgegebenen Zeitdauer ein Zustand erreicht wird, bei dem die an Ausgang A sich aufbauende Gleichspannung der an Eingang E stehenden DC-Offsetspannung ihrer Gröbe entspricht, d.h., es wird erst nach mehreren Schwingungen der in den Sensoren S1, S2 generierten Wechselspannung ein Zustand erreicht, bei dem die Gleichstromverstärkung v = 1 erreicht ist. Um diesen unerwünschten Anlaufvorgang wesentlich zu verkürzen, ist der Verbindungspunkt C von C1 mit R2 über zwei antiparallel-geschaltete Dioden D1, D2 mit dem Ausgang A verbunden. Dadurch wird Kondensator C1 sofort bei Eintreffen eines ersten Maximums der Wechselspannung über den Innenwiderstand einer leitenden Diode auf die DC-Offsetspannung aufgeladen, so daß die über Entkopplungswiderstand R4 dem Komparator OP2 an dessen nicht-invertierenden Eingang zugeführte Wechselspannung sofort nach Einschalten einen DC-Offset aufweist, der in seiner Größe dem am invertierenden Eingang zugeführten DC-Offset entspricht.

In Fig. 1 ist in Reihe mit den antiparallel geschalteten Dioden D1, D2 ein Widerstand R3 eingezeichnet. Dieser Widerstand hat einen Wert, der so gering gehalten ist, daß die Zeitkonstante für den Ladungsvorgang von C1 nicht wesentlich beeinflußt wird. Auch ist es möglich, auf diesen Widerstand zu verzichten. Widerstand R5 zwischen Ausgang von OP2 und dessen nicht-invertierenden Eingang dient der Linearisierung, er ist für Wirkung der Schaltung ohne Bedeutung.

Am Ausgang D von Komparator OP2 entsteht sofort nach dem Einschalten die aus der Eingangswechselspannung umgeformte Rechteckspannung, die, bedingt durch Ungenauigkeiten in der Schaltung, mit einem geringen, aber konstanten DC-Offset behaftet sein kann. Durch Festlegen des Wertes für Kondensator C1 kann der letzte Zustand dieser Rechteckspannung für eine bestimmte Zeit gespeichert werden, so daß bei intermittierendem Betrieb eine durch die Rechteckspannung gesteuerte Motorkommutierung, z.B. für einen Capstanmotor, mit der richtigen Kommutierungsphase weitergeführt werden kann. Durch Einsatz von Magneto-resistance Elementen ist es möglich, auch bei Motorstillstand statisch die Zuordnung der Magnetpolpaare zu den zu kommutierenden Spulen festzustellen.

Fig. 2 zeigt Kurvenverläufe an verschiedenen Punkten der Schaltung nach Fig. 1. In Fig. 2a ist zu erkennen, daß alle Kurven mit einer DC-Offsetspannung behaftet sind. Kurve E zeigt die Eingangswechselspannung an Punkt E, Kurve A die Ausgangswechselspannung am Ausgang A des ersten Operationsverstärkers OP1 und Kurve B den Spannungsverlauf am Verbindungspunkt der Dioden D1, D2 mit R3. Fig. 2b zeigt in Kurve D das Ausgangssignal von Komparartor OP2. Ein geringer DC-Offset, der aber in seinem Wert konstant ist, kann sich durch nicht völlig symmetrische Ausbildung der Schaltung einstellen und ist für die weitere Auswertung des Signales ohne Bedeutung.

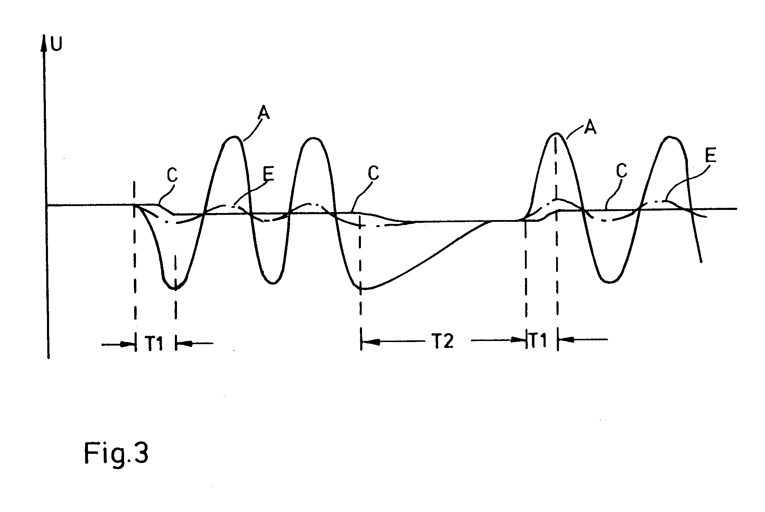

Fig. 3 zeigt Einschwing- und Ausschwingvorgänge in der nach Fig. 1 ausgeführten Schaltung. Nach dem Einschalten wird die Spannung in Kurve C, das ist die Spannung an Kondensator C1, bei Erreichen des ersten Maximums der Ausgangsspannung A mit positiver oder, wie links dargestellt, mit negativer Amplitude in der Zeit T1 auf den DC-Offsetwert eingestellt, d.h., ab Erreichen des ersten Maximums von Spannung A ist diese Spannung konstant. Bei einem Ausschaltvorgang in der Zeit T2 stellt sich die Spannung C auf einen Wert ein, der dem letzten Amplitudenwert der Eingangswechselspannung E zugeordnet ist, wodurch über eine längere Zeit durch die Ladung von Kon densator C1 dieser Wert, d.h., auch die Lage der Magnetpole in ihrer Zuordnung zu den Sensoren für spätere Steuervorgänge gespeichert ist.

In einer ausgeführten Schaltung wurden folgende Bauteile eingesetzt:
S1, S2 = Magneto-resistance-Element DM-106 B, SONY
R1 = 470K, R2 = 33K, R3 = 0,1K, R4 = 22K, R5 = 270k
C1 = 47 uF, D1, D2 = IN4148.

**Patentansprüche**

1. Schaltung zur Umwandlung einer mit einer Gleichspannung -DC-Offset- überlagerten, sinusförmigen

3

Wechselspannung in eine Rechteckspannung, mit zwei Operationsverstärkern, bei der dem ersten, als Verstärker ausgebildeten Operationsverstärker (OP1) die DC-offsetbehaftete sinusförmige Wechselspannung (E) dem nicht-invertierenden und dem zweiten, als Komparator ausgebildeten Operationsverstärker (OP2) dem invertierenden Eingang direkt zugeführt ist, und der Ausgang (A) des ersten Operationsverstärkers (OP1) mit dem nicht-invertierenden Eingang des zweiten Operationsverstärkers (OP2) galvanisch verbunden ist, mit einem Gegenkopplungsnetzwerk zur Einstellung der Verstärkung im ersten Operationsverstärker (OP1), **dadurch gekenneichnet,** daß das Gegenkopplungsnetzwerk durch einen ersten Widerstand (R1) zwischen Ausgang (A) und dem invertierenden Eingang vom ersten Operationsverstärker (OP1), einer mit dem invertierenden Eingang verbundenen Reihenschallung eines zweiten Widerstandes (R2) mit einem mit Bezugspotential (Masse) verbundenen Kondensator (C1), sowie durch zwei, am Verbindungspunkt (C) des zweiten Widerstandes (R2) mit Kondensator (C1) angeschlossene antiparallel geschaltete Dioden (D1, D2,), die mit dem Ausgang (A) verbunden sind, gebildet ist.

2. Schaltung nach Anspruch 1, **dadurch gekennzeichnet,** daß die Wechselspannungsverstärkung im ersten Operationsverstärker (OP1) durch Wahl der Spannungsteilerwiderstände (R1, R2) so eingestellt ist, daß die Wechselspannungsamplitude an seinem Ausgang (A) etwa gleich groß oder geringer als die Summe der Durchlaßspannungen der Dioden (D1, D2) ist.

3. Schaltung nach Anspruch 1, **dadurch gekennzeichnet,** daß die Wechselspannung durch rotierende Magnetpolpaare in statische Magnetfelder dedektierenden Sensoren (S1, S2) erzeugt wird, wobei die erzeugte Wechselspannung eine konstante Maximalamplitude aufweist, die im Wert kleiner als die DC-Offsetspannung ist.

4. Schaltung nach Anspruch 3, **dadurch gekennzeichnet,** daß am Ausgang des zweiten Operationsverstärkers (OP2) eine Rechteckspannung entsteht, deren letzter Zustand auch bei Wegfall der Bewegung der Magnetpole für die Zeitdauer erhalten bleibt, die sich aus der Zeitkonstanten von Kondensator (C1) mit den angeschlossenen Widerständen ergibt.

## Claims

1. Circuit for converting a sinusoidal a.c. voltage superimposed with a d.c. voltage - d.c.-offset - into a square-wave voltage, with two operational amplifiers, in which the d.c.-offset-affected sinusoidal a.c. voltage (E) is fed to the first operational amplifier (OP1), configured as an amplifier, to the non-inverting input and to the second operational amplifier (OP2), configured as a comparator, directly to the inverting input, and the output (A) of the first operational amplifier (OP1) is d.c. connected to the non-inverting input of the second operational amplifier (OP2), with a feedback network for adjusting the gain in the first operational amplifier (OP1), **characterised** in that the feedback network is formed by a first resistor (R1) between output (A) and the inverting input of the first operational amplifier (OP1), a circuit connected to the inverting input and consisting of a second resistor (R2) in series with a capacitor (C1) connected to reference potential (earth), and by two antiparallel connected diodes (D1, D2) connected at the junction point (C) of the second resistor (R2) with the capacitor (C1), said diodes (D1, D2) being connected to the output (A).

2. Circuit according to claim 1, **characterised in that** the a.c. voltage gain in the first operational amplifier (OP1) is adjusted by selecting the voltage divider resistors (R1, R2) in such a way that the a.c. voltage amplitude at its output (A) is approximately equal to or less than the sum of the forward voltapes of the diodes (D1, D2).

3. Circuit according to claim 1, **characterised in that** the a.c. voltage is generated by means of rotating pairs of magnetic poles in sensors (S1, S2) detecting static magnetic fields, the a.c. voltage generated exhibiting a constant maximum amplitude which is smaller in value than the d.c.- offset voltage.

4. Circuit according to claim 3, **characterised in that** at the output of the second operational amplifier (OP2) a square-wave voltage arises whose last state is maintained, even if the movement of the magnetic poles ceases, for the period of time which results from the time constant of capacitor (C1) with the connected resistors.

## Revendications

1. Circuit pour la transformation d'une tension alternative sinusoïdale, à laquelle est superposée une tension continue, offset DC, en une tension rectangulaire avec deux amplificateurs opérationnels dans lequel la tension alternative sinusoïdale (E) dotée d'offset DC est amenée directement au premier amplificateur opérationnel (OP1), configuré comme un amplificateur, à l'entrée directe et au second amplificateur opérationnel (OP2), configuré comme un comparateur, à l'entrée inverseuse et la sortie (A) du premier amplificateur opérationnel (OP1) est reliée par un couplage direct à l'entrée directe du second amplificateur opérationnel (OP2) avec un réseau de contre-réaction pour régler l'amplification dans le premier amplificateur opérationnel (OP1), **caractérisé en ce** que le réseau de contre-réaction est formé par une première résistance (R1) entre la sortie (A) et l'entrée inverseuse du premier amplificateur opérationnel (OP1), un montage en série, constitué par une seconde résistance (R2) avec un condensateur (C1) relié au potentiel de référence (masse), relié à l'entrée inverseuse et par deux diodes (D1, D2) montées en antiparallèle branchées au condensateur (C1) au point de jonction (C) de la seconde résistance (R2), diodes qui sont reliées à la sortie (A).

2. Circuit selon la revendication 1, **caractérisé en ce** que l'amplification de la tension alternative est réglée dans le premier amplificateur opérationnel (OP1) par sélection des résistances du diviseur de tension (R1, R2) de telle manière que l'amplitude de la tension alternative à sa sortie (A) est à peu près égale ou inférieure à la somme des tensions à l'état passant des diodes (D1, D2).

3. Circuit selon la revendication 1, **caractérisé en ce** que la tension alternative est générée par des paires de pôles magnétiques rotatifs dans des capteurs (S1, S2) qui détectent des champs magnétiques statiques, la tension alternative générée présentant une amplitude maximale constante dont la valeur est inférieure à la tension offset DC.

4. Circuit selon la revendication 3, **caractérisé en ce** qu'une tension rectangulaire se forme à la sortie du second amplificateur opérationnel (OP2), tension dont le dernier état reste conservé, même si le déplacement des pôles magnétiques est supprimé, pendant la durée qui résulte de la constante de temps du condensateur (C1) avec les résistances branchées.

Fig.1

Fig.2a

Fig.2b

Fig.3